(19) Europäisches Patentamt
European Patent Office
Office européen des brevets

(11) **EP 4 610 673 A1**

(12) **EUROPÄISCHE PATENTANMELDUNG**

(43) Veröffentlichungstag:
**03.09.2025  Patentblatt 2025/36**

(21) Anmeldenummer: **24160605.2**

(22) Anmeldetag: **29.02.2024**

(51) Internationale Patentklassifikation (IPC):
**G01R 27/26** *(2006.01)*    **G01R 31/64** *(2020.01)*
**G01R 31/26** *(2020.01)*

(52) Gemeinsame Patentklassifikation (CPC):
**G01R 31/2642**; G01N 27/60; G01R 27/26;
G01R 31/2648

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft
80333 München (DE)**

(72) Erfinder:
• **Bickel, Heinz Dietrich Philipp
81677 München (DE)**

• **Kriegel, Kai
81739 München (DE)**
• **Mitic, Gerhard
81827 München (DE)**
• **Stegmeier, Stefan
81825 München (DE)**
• **Walbrecker-Baar, Christian
85757 Karlsfeld (DE)**

(74) Vertreter: **Siemens Patent Attorneys
Postfach 22 16 34
80506 München (DE)**

(54) **VERFAHREN UND SYSTEM ZUR ÜBERPRÜFUNG DES BETRIEBSZUSTANDES EINES LEISTUNGSHALBLEITER-MODULS**

(57)    Die Erfindung betrifft ein Verfahren sowie ein System zur Überprüfung des Betriebszustandes eines Leistungshalbleiter-Moduls.

FIG 2

**Beschreibung**

Die Erfindung betrifft ein Verfahren sowie ein System zur Überprüfung des Betriebszustandes eines Leistungshalbleiter-Moduls.

Leistungshalbleiter-Module weisen eine hohe, aber begrenzte Lebensdauer auf, welche im Wesentlichen aus der thermischen Belastung im Betrieb und insbesondere aus großen Temperaturschwankungen resultiert. Aufgrund der unterschiedlichen Ausdehnungskoeffizienten der Aufbaumaterialien der Module entstehen im Bereich der Verbindungen der unterschiedlichen Materialien thermisch induzierte, mechanische Spannungen, welche schließlich zu Rissen, Delaminationen oder Fehlstellen führen. Die häufigsten Ausfallursachen für Leistungshalbleiter-Module bilden dabei die Bonddrähte und Lotschichten. Typische Fehlermechanismen sind der Bond Lift-Off, das heißt das Abheben bis hin zum Riss des Bonddrahtes, der Heel-Crack oder die Lotermüdung von Chip- und Systemlot, welches das unterliegende Lot des Keramikträgers umfasst. Um einen vorzeitigen Ausfall der elektrischen Bauteile zu verzögern oder zu verhindern, werden die Module üblicherweise mit einer Vergussmasse überzogen oder in diese eingebettet. Die Vergussmasse limitiert beispielsweise den Zutritt von Sauerstoff und/oder Feuchtigkeit und wirkt derart einer Korrosion des Bauteils entgegen. Nach entsprechender Betriebsdauer können jedoch Fremdstoffe in die gealterte Vergussmasse diffundieren, zu den elektronischen Bauteilen gelangen und den Alterungsprozess des Moduls beschleunigen. Durch die Kapselung der Leistungshalbleiter-Module bedingt, ist es im laufenden Betrieb äußerst herausfordernd, die Integrität und die Sicherheit des aktuellen Betriebszustandes abzuschätzen.

Im Rahmen der Modul-Entwicklung haben sich in der Praxis zur Abgabe einer LebensdauerPrognose beschleunigte Alterungstests etabliert. Zu diesen Tests gehören beispielsweise Lastzyklen-Tests oder die direkte Durchführung von Temperaturzyklen. Hierbei wird in standardisierten Versuchsaufbauten eine bestimmte Zyklenzahl vorgegeben, welche ein Modul ohne Verlust der eigentlichen Funktionalität durchlaufen muss. Über eine Temperaturmessung am Modul und mathematische Wahrscheinlichkeitsverteilungen lässt sich dann ein ungefährer Alterungsgrad voraussagen. Der eigentliche Nachweis der tatsächlichen Alterung kann nach den Alterungstests beispielsweise durch ein Öffnen des Moduls und einem Schliff erfolgen. Der zusätzliche Einfluss von Feuchtigkeit oder Fremdstoffen auf die thermische Alterung kann über zusätzliche Tests, wie einem Feuchtigkeitstest, erfolgen. Weiterhin lässt sich der Alterungsgrad von Leistungshalbleiter-Modulen durch diverse Verfahren auch ortsaufgelöst bestimmen. Zu diesen Verfahren zählen beispielsweise das Röntgen, die Ultraschallmikroskopie oder die Thermographie. Diese bildgebenden Verfahren ermöglichen eine Detektion der erwähnten Alterungserscheinungen, jedoch sind diese sehr aufwändig und in den seltensten Fällen in der Anwendungsumgebung des Moduls durchführbar.

Vor diesem Hintergrund des Standes der Technik ist es daher Aufgabe der Erfindung, ein verbessertes Verfahren zur Überprüfung des Betriebszustandes eines Leistungshalbleiter-Moduls sowie ein System zur Ausführung dieses verbesserten Verfahrens zu schaffen. Insbesondere soll mit dem erfindungsgemäßen Verfahren zur Überprüfung des Betriebszustandes eine einfache, kostengünstige und zuverlässige Überprüfung der Alterung und/oder des Alterungsgrades des Leistungshalbleiter-Moduls in der Betriebsumgebung und unter Betriebsbedingungen ermöglicht werden.

Diese Aufgabe der Erfindung wird mit einem Verfahren zur Überprüfung des Leistungshalbleiter-Moduls mit den in Anspruch 1 angegebenen Merkmalen sowie mit einem System mit den in Anspruch 10 angegebenen Merkmalen gelöst.

Bevorzugte Weiterbildungen der Erfindung sind in den zugehörigen Unteransprüchen, der nachfolgenden Beschreibung und der Zeichnung angegeben.

Das erfindungsgemäße Verfahren ist ein Verfahren zur Überprüfung des Betriebszustandes eines Leistungshalbleiter-Moduls, wobei das Leistungshalbleiter-Modul ein oder mehrere zumindest teilweise durch eine Vergussmasse überzogene, elektronische Bauteile in einem Gehäuse, umfasst, wobei das Verfahren mindestens die Schritte umfasst:

a) Bestimmung der elektrischen Eigenschaften mindestens einer innerhalb des Halbleiter-Moduls liegenden kapazitativen Anordnung aus zwei voneinander beabstandeten, leitenden, gegeneinander elektrisch isolierten Komponenten und einem elektrischen Isolator in Form eines zwischen diesen Komponenten liegenden Teils der Vergussmasse, wobei der Isolator sich zumindest teilweise zwischen den leitenden, gegeneinander elektrisch isolierten Komponenten erstreckt und diese jeweils an einer Oberfläche kontaktiert;

b) Vergleich der im Verfahrensschritt a) bestimmten, elektrischen Eigenschaften mit einem vorgegebenen Referenzwert;

c) Ausgeben einer Mitteilung und/oder Ablegen des Vergleichsergebnisses in einem elektronischen Speicher.

Überraschend wurde gefunden, dass durch die Bestimmung der elektrischen Eigenschaften eines kapazitativen Aufbaus innerhalb des Moduls eine Änderung in den elektrischen Eigenschaften der Vergussmasse erfasst werden kann, welche im hohen Maße mit dem Alterungsgrad der Vergussmasse und dem Alterungsgrad des eigentlichen Leistungsmoduls korreliert. Die Messung liefert einen quantitativen Wert und ist im hohen Maße reproduzierbar. Aus der Messung ergibt sich ein integraler Parameter, welcher zum einen proportional zur thermischen Belastung des Moduls ist und zudem noch sensitiv auf die Eigenschaften und die chemische Umgebung der Vergussmasse abzielt. Diesem Ansatz liegt zugrunde, dass die Barriereeigenschaften der Vergussmasse sowohl durch die thermische Alterung der Vergussmasse als auch über die chemische Umgebung innerhalb des Moduls beeinflusst werden. So kann das Eindiffundieren von Fremdsubstanzen in die Vergussmasse einmal direkt proportional zur Anzahl der Fremdsubstanzen in der Vergussmasse sein, welches dann eine Aussage über eine mögliche Leckage im Modul ermöglicht. Zum anderen kann ein erhöhter chemischer Abbau der Vergussmasse, beispielsweise durch häufige und hohe Temperaturzyklen bedingt, zu einer verringerten Barriereleistung der Vergussmasse als solche führen. Beide Ursachen ergeben, dass die elektrischen Eigenschaften der Vergussmasse sich über den Eintrag der Fremdsubstanzen ändern. Diese Änderung kann erfindungsgemäß integral über die Messung der elektrischen Eigenschaften der Vergussmasse abgegriffen werden. Neben einer aktuellen Bestimmung des Zustandes der Vergussmasse kann dieser Wert in eine Restlebensdauerprognose für das Modul einfließen oder verwendet werden, da die Restlebensdauer im hohen Maße mit der Schutzwirkung der Vergussmasse und diese wiederum mit der korrosiven Belastung des Moduls verknüpft ist.

Das erfindungsgemäße Verfahren ist ein Verfahren zur Überprüfung des Betriebszustandes eines Leistungshalbleiter-Moduls. Leistungshalbleiter-Module sind Bauelemente der Leistungselektronik, wie beispielsweise bipolare Leistungstransistoren, wie Schaltnetzteile und DC/DC-Wandler, Leistungs-MOSFET, IGBTs, Motorsteuerungen und Umrichter, außerdem Thyristoren, insbesondere Stromrichter, Halbleiterrelais, Impulsstromquellen, Ansteuerungen von Thyristoren, oder GTO-Thyristoren, solange deren Aufbau einen Überzug elektronischer Komponenten mit einer Vergussmasse beinhält. Das Verfahren zur Überprüfung des Betriebszustandes beinhaltet zumindest die quantitative Erfassung und Auswertung eines elektrischen Parameters, welcher Aussagen über die Eignung des Moduls zur weiteren Erfüllung der Modulaufgaben ermöglicht. Der Betriebszustand kann beispielsweise dahingehend qualifiziert werden, dass das Modul im Rahmen der üblichen Parameter funktioniert. Die Erhebung des Parameters kann aber auch ergeben, dass der quantitativ erhaltene Wert außerhalb eines festgelegten Bereiches liegt und somit eine Fehlfunktion oder ein baldiges Versagen des Moduls nicht ausgeschlossen werden kann. Insofern kann die Überprüfung des Betriebszustandes ergeben, das ist Modul sofort oder aber innerhalb einer festgelegten oder berechneten Zeitspanne ausgetauscht werden soll. Das Verfahren ermöglicht somit eine verlässlichere, nicht-destruktive, im Bauteilbetrieb vornehmbare Detektion alterungsbedingter Schäden oder Delaminationen an leistungselektronischen Baugruppen sowie an einzelnen Bauteilen dieser Baugruppen, insbesondere für Leistungsmodule in leistungselektronischen Geräten.

Das Leistungshalbleiter-Modul umfasst ein oder mehrere zumindest teilweise durch eine Vergussmasse überzogene, elektronische Bauteile in einem Gehäuse. Der Aufbau eines Leistungshalbleiter-Moduls kann für die elektronischen Komponenten ohne die kapazitative Anordnung im Wesentlichen dem Aufbau eines üblichen Moduls entsprechen. Zu dem Aufbau kann der eigentliche Leistungshalbleiter, ein Bonddraht, ein Keramiksubstrat und diverse Metallbeschichtungen auf dem Keramiksubstrat gehören. Als Substrat wird in diesen Fällen nur das Trägermaterial, beispielsweise in Form eines Keramikträgers bezeichnet. Das Substrat mit weiteren Bestandteilen, wie beispielsweise die Leitungsbahnen, kann dann als DCB-Substrat bezeichnet werden. Diese elektrischen Komponenten werden gegenüber der Umgebung durch einen Überzug geschützt. Der Überzug wird auf die elektronischen Komponenten aufgebracht und bedeckt vorzugsweise die gesamten elektronischen Komponenten. Beispielsweise kann der Überzug oder die Vergussmasse auf die elektronischen Bauteile durch Aufgießen einer verflüssigten Vergussmasse aufgebracht werden. Die Vergussmasse härtet beim Abkühlen aus und erhöht ihre Viskosität. Als Vergussmasse eignen sich beispielsweise thermoplastische Polymere oder aber beispielsweise Silikon. Bevorzugt können die elektronischen Bauteile ganz mit einer Vergussmasse überzogen sein. Bevorzugt sind die elektronischen Bauteile mindestens mit einer 0,5 Millimeter dicken, des Weiteren bevorzugt mit einer 1,5 Millimeter dicken und weiterhin bevorzugt mit mindestens einer 5 Millimeter dicken Schicht der Vergussmasse überzogen. Die Vergussmasse eignet sich insbesondere dazu, dass die elektronischen Bauteile gegenüber dem Zutritt ungewollter Fremdstoffe, wie beispielsweise reaktive Gase, Partikel oder Feuchte, geschützt werden. Der Zutritt dieser Fremdstoffe wird eigentlich durch das Modulgehäuse gewährleistet, welches das eigentliche Modul umgibt. Aufgrund von möglicherweise auftretenden Leckagen des Gehäuses kann dieses aber allein den Zutritt von Fremdstoffen nicht 100%ig verhindern.

Das Verfahren umfasst den Verfahrensschritt a), wobei innerhalb dieses Verfahrensschrittes die Bestimmung der elektrischen Eigenschaften mindestens einer innerhalb des Halbleiter-Moduls liegenden kapazitativen Anordnung aus zwei voneinander beabstandeten, leitenden, gegeneinander elektrisch isolierten Komponenten und einem elektrischen Isolator in Form eines zwischen diesen Komponenten liegenden Teils der Vergussmasse erfolgt. Der Isolator erstreckt sich zumindest teilweise zwischen den leitenden, gegeneinander elektrisch isolierten Komponenten und kontaktiert diese jeweils an einer Oberfläche. Die Oberflächen liegen sich gegenüber und werden durch die Vergussmasse getrennt. Im Halbleitermodul wird neben dem zum Funktionieren des Halbleiters nötigen elektronischen Komponenten eine weitere elektrische Funktionalität aufgebaut. Diese weitere elektrische Funktionalität liegt in Form einer elektrischen Kapazität vor. Die Kapazität wird durch zwei elektrische Komponenten, beispielsweise in Form von Metallen, ausgebildet, welche sich gegeneinander nicht physikalisch oder "direkt elektrisch kontaktieren. Der Abstand zwischen den beiden Metallen wird, zumindest teilweise, durch die Vergussmasse ausgefüllt. Die Vergussmasse bildet insofern das zwischen den beiden Metallen befindliche Dielektrikum der Kapazität. Die Eigenschaften der elektrischen Kapazität werden dabei insbesondere durch die Eigenschaften der Vergussmasse bestimmt. Als gegeneinander elektrisch isolierte Komponenten können teilweise Komponenten verwendet werden, welche elektrische Komponenten des Moduls darstellen. Es ist aber auch möglich, dass die gegeneinander elektrisch isolierten Komponenten zusätzlich zu den Komponenten des Moduls hinzutreten. Auch möglich ist, dass eine elektrische Komponente des Moduls und eine weitere, zusätzlich hinzutretende Komponente verwendet werden. Die gegeneinander elektrisch isolierten Komponenten weisen jeweils eine elektrische Anbindung auf, welche zur Bestimmung der elektrischen Eigenschaften der kapazitativen Anordnung verwendet werden kann. Dies bedeutet, dass jede der voneinander beanstandeten, leitenden, gegeneinander elektrisch isolierten Komponenten eine solche Anbindung, beispielsweise in Form eines Kabels oder Drahtes, aufweist. Bevorzugt kann der gesamte Abstand zwischen den gegeneinander elektrisch isolierten Komponenten durch die Vergussmasse ausgefüllt sein. Der Aufbau kann in Form eines Plattenkondensators ausgeführt sein, dessen Kapazität durch die allgemeine bekannte Formel

$$C = \varepsilon_0 \varepsilon_r \frac{A}{d}$$

definiert ist. In der Berechnung der Kapazität C bildet $\varepsilon_0$ als Naturkonstante einen festen Wert. Mit festgelegter Oberfläche A und Abstand d zwischen den Komponenten ist der Wert der Kapazität nur durch die relative Permittivität $\varepsilon_r$ des Dielektrikums als Parameter festgelegt. Diese relative Permittivität ist eine Materialkonstante, welche für Luft beispielsweise 1 und für Silikon ca. 3 beträgt. Unter Eindringen von Fremdstoffen in die Vergussmasse, beispielsweise ein Silikongel, ändert sich die Kapazität signifikant und reproduzierbar. Die elektrischen Eigenschaften der Anordnung können kontinuierlich oder in festgelegten Intervallen gemessen werden. Es ist auch möglich, dass die elektrischen Eigenschaften der kapazitativen Anordnung im Rahmen einer Wartung, beispielsweise durch eine aktive Messung der elektrischen Eigenschaften durch einen Bediener abgefragt werden.

Das Verfahren umfasst den Verfahrensschritt b), wobei innerhalb dieses Schrittes ein Vergleich der im Verfahrensschritt a) bestimmten, elektrischen Eigenschaften mit einem vorgegebenen Referenzwert erfolgt. Der in Verfahrensschritt a) bestimmte Wert wird innerhalb dieses Verfahrensschrittes mit einem bekannten, schon einmal gemessenen, oder theoretisch bestimmten Wert verglichen. Der Referenzwert kann beispielsweise der gemessene Wert an einem neuen, d.h. nicht gealterten Modul sein. Es ist auch möglich, dass der Referenzwert ein Mittelwert der letzten Messungen am Modul darstellt. Alternativ kann der Referenzwert rein rechnerisch aus der bekannten Geometrie der kapazitativen Anordnung und einem theoretischen Wert eines idealen Dielektrikums berechnet werden. Ein weiteres Modell kann beinhalten, das für eine Mehrzahl an Modulen ein natürlicher Alterungsprozess unter Betriebsbedingungen nachgestellt wird. Die Referenzwerte als Funktion der Betriebsdauer ergeben sich dann als Mittelwerte der gemessenen elektrischen Eigenschaften der kapazitativen Anordnung der betrachteten Module. Bei dem Referenzwert kann es sich auch um einen Referenzbereich handeln. Der Referenzbereich kann beispielsweise die Standardabweichung der Mittelwerte im letzten Modell als Bereichsgrenzen umfassen. Der Vergleich der beiden Werte, gemessen gegen Referenz, kann beispielsweise eine Subtraktion des gemessenen Wertes vom Referenzwert umfassen. Als Funktion der resultierenden Differenz aus gemessenen und Referenzwert kann auf einen vergleichbaren, besseren oder schlechteren Zustand des Moduls im Vergleich zur gewählten Referenz geschlossen werden. Der Vergleich kann eine Temperaturkompensation oder -korrektur der aktuell gemessenen Werte beinhalten.

Das Verfahren umfasst den Verfahrensschritt c), wobei innerhalb dieses Schrittes ein Ausgeben einer Mitteilung und/oder ein Ablegen des Vergleichsergebnisses in einem elektronischen Speicher erfolgt. Der Vergleich der gemessenen Größe mit dem hinterlegten Referenzwert kann innerhalb dieses Verfahrensschrittes entweder in einem Speicher abgelegt werden, welcher nach dem Ablegen die Vergleichsergebnisse beispielsweise als Funktion der Zeit aufweist. Es ist aber auch möglich, dass eine Mitteilung in Form eines akustischen oder eines optischen Signals ausgegeben wird. Beispielsweise kann dies in Form einer Leuchtdiode erfolgen, welche bei einem Zustand innerhalb eines vorgegebenen Referenzwertebereiches "grün" und bei einem Zustand des Moduls mit elektrischen Eigenschaften der kapazitativen Anordnung außerhalb des vorgegebenen Referenzwertes "rot" anzeigt. Das Ablegen des Vergleichsergebnisses in einem elektronischen Speicher kann beispielsweise noch weitere Schritte umfassen. Die weiteren Schritte können beispielsweise darin bestehen, dass die Differenz zu vorherigen Werten bestimmt und daraus ein Trend berechnet wird. Insofern können aus mehreren, aufgenommenen Datenpunkten oder Vergleichsergebnissen Trendgrößen bestimmt werden. Dies kann die Aussagefähigkeit bezüglich zeitlicher Veränderungen im Modul und die Statistik des Verfahrens verbessern.

In einer bevorzugten Ausführungsform des Verfahrens können die zwei voneinander beabstandeten, leitenden, gegeneinander elektrisch isolierten Komponenten elektronische Bauteile des Leistungshalbleiter-Moduls sein. Zum Aufbau der kapazitativen Anordnung hat es sich als besonders günstig herausgestellt, dass elektronische Bauteile des Leistungsmoduls selbst zum Aufbau der elektrischen Kapazität verwendet werden. Beispielsweise können die Kupferkontakte auf der Keramik als Platten eines Plattenkondensators fungieren. Ist der Abstand zwischen den Kupferkontakten auf der Keramik durch die Vergussmasse ausgefüllt und werden die elektronischen Bauteile separat zur Ausführung der Messung kontaktiert, ergibt sich die erfindungsgemäße kapazitive Anordnung. Die die zwei voneinander beabstandeten, leitenden, gegeneinander elektrisch isolierten Komponenten können also beispielsweise die Kupferleitungsbahnen auf der Keramik des Moduls sein. Zum Abgreifen der elektrischen Eigenschaften der kapazitiven Anordnung weist jeder der beiden Kupferkontakte auf der Keramik eine eigene elektrische Kontaktierung auf, über welche die elektrischen Eigenschaften der Anordnung bestimmt werden kann. Diese Kontaktierung ist kein Bestandteil üblicher Aufbauten von Leistungsmodulen. Bevorzugt können die beiden Kupferkontakte auf der Keramik benachbart angeordnet sein.

In einer weiter bevorzugten Ausgestaltung des Verfahrens kann der Verfahrensschritt a) unabhängig voneinander an zwei voneinander beabstandeten, kapazitiven Anordnungen innerhalb des Leistungshalbleiter-Modul durchgeführt werden und der Vergleich im Verfahrensschritt b) auf Basis der elektrischen Eigenschaften beider Anordnungen erfolgen. Zur umfassenderen Bestimmung des Betriebszustandes des Leistungsmoduls hat es sich als besonders günstig herausgestellt, dass zwei unterschiedliche kapazitive Anordnungen verwendet werden. Die beiden Anordnungen können beispielsweise durch eine unterschiedliche Menge an Vergussmasse geschützt im Modul vorliegen. So kann beispielsweise eine der Anordnung relativ nahe an der Oberfläche der Vergussmasse angeordnet sein und als Frühindikator für Änderungen an der Vergussmasse fungieren. Die weitere Anordnung kann beispielsweise eher im Inneren des Moduls vorliegen, wobei diese Anordnung dann durch eine größere Menge an Vergussmasse oder durch eine weitere Strecke durch die Vergussmasse hindurch geschützt wird. Eindiffundierende Fremdstoffe erreichen diese Anordnung zu einem späteren Zeitpunkt. Durch das Messen der elektrischen Eigenschaften beider Anordnungen und die Einzelbetrachtung der gemessenen Werte kann ein umfassenderes Bild über die aktuelle Betriebssituation des Moduls erstellt werden.

Insbesondere aufgrund der Erfassung von Werten an unterschiedlichen Stellen des Moduls kann eine verbesserte Langzeitprognose für den Betriebszustand erfolgen. Bevorzugt kann die eine Anordnung im Inneren des Moduls elektrische Bestandteile des Moduls selbst aufweisen, während die zweite Anordnung, welche näher an der Oberfläche der Vergussmasse liegt, durch eigens eingebrachte elektrische Bestandteile ausgebildet sein kann. Bevorzugt kann eine Anordnung eine kürzeste Strecke zur Oberfläche der Vergussmasse von größer oder gleich 2 Millimeter und kleiner oder gleich 10 Millimeter und die andere Anordnung eine kürzeste Strecke zur Oberfläche der Vergussmasse von größer oder gleich 4 Millimeter und kleiner oder gleich 12 Millimeter aufweisen.

In einer bevorzugten Charakteristik des Verfahrens kann die Bestimmung der elektrischen Eigenschaften im Verfahrensschritt b) die Bestimmung der elektrischen Kapazität der kapazitiven Anordnung umfassen. Die kapazitive Anordnung kann beispielsweise in Form eines Plattenkondensators vorliegen, wobei das Dielektrikum des Plattenkondensators über die Vergussmasse bereitgestellt wird. Wie schon weiter oben ausgeführt, werden die elektrischen Eigenschaften des Plattenkondensators bei festgelegter Geometrie des Plattenkondensators im Wesentlichen über die die elektrischen Eigenschaften des Dielektrikums bestimmt. Diese elektrischen Eigenschaften des Dielektrikums sind sehr sensitiv gegenüber der Präsenz von Fremdstoffen, wie beispielsweise Feuchte. Als Funktion der Alterung der Vergussmasse können vermehrt Fremdstoffe in die Vergussmasse eintreten und die Kapazität des Plattenkondensators gegenüber einem Referenzwert verändern. Die elektrische Kapazität des Plattenkondensators erlaubt unter Rückbezug auf einem Referenzwert also einen Rückschluss auf die Qualität der Vergussmasse und somit auch der elektrischen Komponenten des Leistungsmoduls.

In einer weiter bevorzugten Ausführungsform des Verfahrens kann die Bestimmung der elektrischen Eigenschaften im Verfahrensschritt b) die Bestimmung der Impedanz der kapazitiven Anordnung umfassen. Neben der Bestimmung der Kapazität der kapazitiven Anordnung kann auch die Impedanz der Anordnung als Größe zur quantitativen Bestimmung des Betriebszustandes des Leistungsmoduls herangezogen werden. Die Impedanzmessung kann beispielsweise mittels eines Frequenzsweeps gemessen werden.

In einer weiter bevorzugten Ausgestaltung des Verfahrens kann die Bestimmung der elektrischen Eigenschaften im Verfahrensschritt b) die Bestimmung eines Verlustwinkels und/oder eines Verlustfaktors der kapazitiven Anordnung umfassen. Neben der Bestimmung der reinen elektrischen Kapazität der kapazitiven Anordnung haben sich auch weitere dynamische Messungen zur Bestimmung der elektrischen Eigenschaften der kapazitiven Anordnung als geeignet herausgestellt. So können beispielsweise mittels einer dynamischen Messung der Verlustwinkel und der Verlustfaktor der kapazitiven Anordnung bestimmt und ausgewertet werden. Diese beiden dynamischen Größen der elektrischen Kapazität können ein detailliertes Bild über den derzeitigen Betriebszustand des Leistungsmoduls liefern und in besonderen Fällen dazu beitragen, das unterschiedliche Ursachen für die Alterung des Leistungsmoduls weiter differenziert werden können.

In einer bevorzugten Ausführungsform des Verfahrens kann im Verfahrensschritt c) der Vergleich der gemessenen, elektrischen Eigenschaften mit einem vorgegebenen Referenzwert einen Vergleich mit den elektrischen Eigenschaften eines neuen Leistungshalbleiter-Moduls umfassen. Zum Vergleich der gemessenen mit den Referenzwerten der kapazitativen Anordnung hat es sich als besonders geeignet herausgestellt, dass als Vergleichsbasis die Ergebnisse neuer Leistungsmodule herangezogen werden. Hierzu kann ein Wert des konkret vorliegenden Leistungsmoduls bestimmt werden. Alternativ ist es auch möglich, dass ein Mittelwert über mehrere Module derselben Baureihe bestimmt und als Referenzwert hinterlegt wird. Das Heranziehen realer Messwerte an Leistungsmodulen derselben Baureihe kann im Vergleich zu theoretisch berechneten Referenzwerten deutliche Vorteile aufweisen.

In einer weiterhin bevorzugten Charakteristik des Verfahrens kann im Verfahrensschritt c) der Vergleich der gemessenen, elektrischen Eigenschaften mit einem vorgegebenen Referenzwert einen Vergleich mit den Werten einer Kalibrationskurve umfassen, wobei die Kalibrationskurve die elektrischen Eigenschaften der kapazitativen Anordnung als Funktion der Eigenschaften der Vergussmasse umfasst. Zur Bestimmung geeigneter Referenzwerte können auch extra hergestellte Proben beitragen, welche einen definierten Fremdstoffgehalt aufweisen. So können beispielsweise Leistungsmodule mit Vergussmassen mit unterschiedlichem Feuchtegehalt hergestellt und die elektrischen Eigenschaften der kapazitativen Anordnung dieser Proben bestimmt werden. Die Kalibrationsproben ermöglichen die Ausgabe oder das Abspeichern eines zurückgerechneten Feuchtewertes. Diese Bestimmung der Referenzwerte kann sich insbesondere in den Fällen anbieten, in denen ein Fremdstoff die Alterung der Vergussmasse und des Leistungsmoduls dominiert.

In einer bevorzugten Ausgestaltung des Verfahrens kann im Verfahrensschritt a) die Bestimmung der elektrischen Eigenschaften eine Messung einer elektrischen Teilentladung der kapazitativen Anordnung umfassen. Neben der Bestimmung der statischen elektrischen Eigenschaften der kapazitativen Anordnung kann auch eine dynamische Messung, welche die elektrische Kapazität der Anordnung und die elektrischen Eigenschaften nach einer Teilentladung der Kapazität umfasst, zu einem umfassenderen Bild der elektrischen Eigenschaften der Vergussmasse beitragen. Es können somit zwei getrennte elektrische Parameter erhalten werden, welche weitere qualitative oder quantitative Aussagen über den Fremdstoffeintrag in die Vergussmasse und die damit verbundene Betriebsfähigkeit des Leistungsmoduls erlaubt.

Des Weiterhin erfindungsgemäß ist ein System zur Bestimmung des Betriebszustandes eines Leistungshalbleiter-Moduls, wobei das System mindestens umfasst:

i) ein Leistungshalbleiter-Modul, umfassend elektronische Bauteile und eine Vergussmasse in einem Gehäuse, wobei die Vergussmasse zumindest Teile der Oberfläche der elektronischen Bauteile bedeckt;
ii) eine kapazitative Anordnung, wobei die kapazitative Anordnung aus zwei voneinander beabstandeten, leitenden, gegeneinander elektrisch isolierten Komponenten und einem elektrischen Isolator in Form eines zwischen diesen Komponenten liegenden Teils der Vergussmasse besteht, wobei der Isolator sich zumindest teilweise zwischen den leitenden, gegeneinander elektrisch isolierten Komponenten erstreckt und diese jeweils an einer Oberfläche kontaktiert;
iii) eine Messeinrichtung eingerichtet zur Bestimmung der elektrischen Eigenschaften der kapazitativen Anordnung;
iv) eine Auswerteeinheit dazu eingerichtet einen Vergleich zwischen gemessenen Werten und Referenzwerten durchzuführen;
v) eine Anzeige und/oder eine Speichereinheit.

Überraschend wurde gefunden, dass sich über oben angegebenes System der Betriebszustand eines Leistungsmoduls verlässlich und reproduzierbar bestimmen lässt. Insbesondere können über das erfindungsgemäße System Alterungserscheinungen am Modul erkannt und eine Restbetriebsdauer des Moduls prognostiziert werden. Alternativ ist es auch möglich, dass über das System eine Wartung des Moduls oder ein Austausch initiiert oder angezeigt wird. Der Alterungszustand des Moduls wird indirekt über die elektrischen Eigenschaften der Vergussmasse bestimmt, welche sensitiv auf die Einlagerungen von Fremdstoffen reagiert. Die in die Vergussmasse eingelagerten Fremdstoffe wirken sich negativ auf die mechanischen oder die elektrischen Eigenschaften des Moduls selbst aus. So kann beispielsweise mit einem erhöhten Feuchtegehalt der Vergussmasse auf eine erhöhte Korrosionsneigung des Moduls und eine höhere thermische oder mechanische Anfälligkeit geschlossen werden. Die kapazitative Anordnung liefert insofern Werte, welche integral die thermische und Fremdstoffbelastung abbilden, da beide Komponenten die Alterung und die Diffusionseigenschaften der Vergussmasse beeinflussen. Ein weiterer Vorteil des erfindungsgemäßen Systems bietet demnach die Möglichkeit einer Zustandsüberwachung, auf der eine Restlebensdauerbestimmung basieren kann. Es werden ungeplante Ausfälle des Moduls vermieden und eine vorausschauende Wartung ermöglicht. Des Weiteren ergibt sich eine kostengünstige Lösung für die Zustandsüberwachung von gesamten Leistungsmodulen in Umrichtern, welche auch für eine Lebensdauerprognose nutzbar ist. Zu den weiteren Vorteilen des erfindungsgemäßen Systems wird explizit auf die im Rahmen des erfindungsgemäßen Verfahrens diskutierten Vorteile Bezug genommen.

Das erfindungsgemäße System ist ein System zur Bestimmung des Betriebszustandes eines Leistungshalbleiter-Moduls. Typische Bauelemente der Leistungselektronik sind weiter oben im Rahmen des erfindungsgemäßen Verfahrens angegeben.

Das System umfasst i) ein Leistungshalbleiter-Modul, umfassend elektronische Bauteile und eine Vergussmasse in einem Gehäuse, wobei die Vergussmasse zumindest Teile der Oberfläche der elektronischen Bauteile bedeckt. Grundlage des Systems bilden bekannte Leistungsmodule, wie sie beispielsweise schematisch in den Figuren dargestellt sind. Die elektrischen Komponenten der Leistungsmodule sind in eine Schutzschicht eingebettet oder mit dieser überzogen, welche neben dem Gehäuse die elektrischen Komponenten vor dem Kontakt mit Fremdstoffen, wie beispielsweise Sauerstoff oder Feuchte, schützt.

Das System umfasst ii) eine kapazitative Anordnung, wobei die kapazitative Anordnung aus zwei voneinander beabstandeten, leitenden, gegeneinander elektrisch isolierten Komponenten und einem elektrischen Isolator in Form eines zwischen diesen Komponenten liegenden Teils der Vergussmasse besteht, wobei der Isolator sich zumindest teilweise zwischen den leitenden, gegeneinander elektrisch isolierten Komponenten erstreckt und diese jeweils an einer Oberfläche kontaktiert. Die kapazitative Anordnung befindet sich also in der Nähe der elektronischen Bauteile des Leistungsmoduls und teilt sich mit dem Leistungsmodul eine Untermenge der Vergussmasse. Die kapazitative Anordnung kann beispielsweise in Form eines Plattenkondensators ausgebildet sein, wobei die Vergussmasse das Dielektrikum des Kondensators darstellt und sich zwischen diesen erstreckt. Bevorzugt kann die Vergussmasse den Raum zwischen den beiden beabstandeten, leitenden, gegeneinander elektrisch isolierten Komponenten ganz ausfüllen. Die beabstandeten, leitenden, gegeneinander elektrisch isolierten Komponenten können beispielsweise flächig in Form von Metallplatten oder - Scheiben vorliegen. Die gegeneinander elektrisch isolierten Komponenten können jeweils durch eine elektrische Anbindung, beispielsweise in Form eines Drahtes oder Kabels, elektrisch kontaktiert sein.

Das System umfasst iii) eine Messeinrichtung eingerichtet zur Bestimmung der elektrischen Eigenschaften der kapazitativen Anordnung. Die Messeinrichtung ist dazu geeignet, elektrische Eigenschaften der kapazitativen Anordnung kontinuierlich oder in bestimmten Zeitintervallen zu erfassen. Als Messeinrichtung kommen diejenigen Vorrichtungen in Frage, welche dem Prinzip nach zur Bestimmung der elektrischen Eigenschaften von Plattenkondensatoren geeignet sind. Die Messeinrichtung kontaktiert die elektrischen Zuleitungen der kapazitativen Anordnung und kann weitere Mittel zu Kontaktierung einer Auswerte- oder einer Speichereinrichtung aufweisen. Alternativ oder zusätzlich kann die Messeinrichtung auch eine Anzeigevorrichtung kontaktieren.

Das System umfasst iv) eine Auswerteeinheit dazu eingerichtet einen Vergleich zwischen gemessenen Werten und Referenzwerten durchzuführen. Die Auswerteeinheit kann mathematische Operationen durchführen und somit eine Relation zwischen aktuell gemessenen Werten und Standartwerten herbeiführen. Die Relation zwischen den Werten kann sich beispielsweise über eine Subtraktion oder eine Division der Werte ergeben. Es können aber auch komplexere mathematische Operationen, wie beispielsweise eine Mittelwertbildung oder eine Ableitung, über die Auswerteeinheit ausgeführt werden.

Das System umfasst v) eine Anzeige und/oder eine Speichereinheit. Die Anzeigeeinheit oder die Speichereinheit kann direkt mit der kapazitativen Anordnung verbunden sein. Somit ist es beispielsweise möglich, dass über die Anzeigeeinheit der gemessene Wert der Messeinrichtung stetig ausgegeben wird. Alternativ ist es auch möglich, dass die Anzeigeeinheit nur bei Bedarf die gemessenen Werte der Messeinrichtung oder das Ergebnis des Vergleiches anzeigt. Die Anzeige kann aber auch dazu eingerichtet sein, nur das Ergebnis des Vergleiches anzuzeigen, beispielsweise in Form einer Farbkodierung, welche den aktuellen Betriebszustand des Leistungsmoduls ausgibt. Diese Werte des Vergleichs oder davon abgeleitete Werte mathematischer Operationen können ebenfalls in der Speichereinheit abgelegt und beispielsweise über eine Schnittstelle ausgelesen werden. Die Anzeigeeinheit kann am Leistungsmodul angeordnet sein. Es ist aber auch möglich, dass die Anzeigeeinheit über ein Kommunikationsmittel mit der Auswerteeinheit oder der Speichereinheit verbunden und nicht direkt am Leistungsmodul angeordnet ist.

In einer bevorzugten Ausführungsform des Systems können die voneinander beabstandeten, leitenden, gegeneinander elektrisch isolierten Komponenten der kapazitativen Anordnung zwei Kupferleiterbahnen auf einem Substrat des Leistungshalbleiter-Moduls sein. In dieser Ausgestaltung können die Kupferleiterbahnen auf dem Substrat des Leistungshalbleiter-Moduls jeweils über eine Leitung elektrisch angebunden und mit der Messeinrichtung verbunden sein. Dies kann den zusätzlichen Aufwand zur kontinuierlichen Überwachung des Betriebszustandes des Moduls verringern. Zudem können in dieser Ausgestaltung signifikantere Werte für die Betriebszustand des Moduls erhalten werden, da die Änderungen in den elektrischen Eigenschaften der kapazitativen Anordnung gegebenenfalls auch von Veränderungen der Kupfer Leiterbahnen herrühren können.

In einer weiter bevorzugten Ausgestaltung des Systems können die voneinander beabstandeten, leitenden, gegeneinander elektrisch isolierten Komponenten der kapazitativen Anordnung zwei Metallplatten sein, wobei die Metallplatten die elektronischen Bauteile des Leistungshalbleiter-Moduls nicht kontaktieren. In dieser Ausgestaltung wird die kapazitive Anordnung über einen Plattenkondensator realisiert, wobei die Platten des Kondensators zusätzlich in das Leistungsmodul eingebracht werden. Das Dielektrikum des Plattenkondensators wird durch die Vergussmasse gebildet, welche standardmäßig zum Schutz des Moduls aufgebracht wird.

In einer weiter bevorzugten Ausführungsform des Systems können die voneinander beabstandeten, leitenden, gegeneinander elektrisch isolierten Komponenten der kapazitativen Anordnung durch eine Kupferleiterbahn auf einem Substrat des Leistungshalbleiter-Moduls und aus einem Metallkontakt in Plattenform ausgebildet sein, wobei der Metallkontakt in Plattenform die elektronischen Bauteile des Leistungshalbleiter-Moduls nicht kontaktiert. Die kapazitative Anordnung wird in diesem Fall also nur teilweise durch ein Standardbauteil des Moduls ausgeführt. Zusätzlich zu den schon standardmäßig im Modul vorhandenen Kupferleiterbahnen auf dem Substrat wird ein zusätzlicher Metallkontakt eingebracht, welcher von der Kupferleiterbahn beabstandet ist. Der Zwischenraum zwischen der Kupferleiterbahn und dem zusätzlichen Metallkontakt wird durch die Vergussmasse ausgefüllt. Diese Ausführungsform hat den Vorteil, dass die Messung an besonders wichtigen Stellen des Moduls selektiv durchgeführt werden kann. Man kann diesen Aufbau also spezifisch an denjenigen Stellen anordnen, welche für die Leistung des Moduls besonders wichtig sind oder welche sich in der Vergangenheit für Korrosion besonders anfällig gezeigt haben. Diese Ausgestaltung kann den zusätzlichen Aufwand zur Bestimmung der elektrischen Eigenschaften der Vergussmasse verringern.

In einer weiter bevorzugten Ausgestaltung des Systems kann zumindest im Bereich der kapazitativen Anordnung die Vergussmasse ein derivatisiertes Silikongel sein, wobei das derivatisierte Silikongel dazu eingerichtet ist, selektiv spezifische Substanzen zu absorbieren und seine elektrischen Eigenschaften als Funktion der absorbierten Stoffmenge der spezifischen Substanz zu ändern. Über eine chemische Modifikation bekannter Silikon-Gele kann erreicht werden, dass das Silikongel seine elektrischen Eigenschaften als Funktion der Einlagerung spezifischer Fremdstoffe stärker ändert. Insofern kann die Sensitivität der Kapazität in Bezug auf die spezifisch ausgewählten Fremdstoffe erhöht werden. Das derivatisierte Silikongel weist insofern zusätzliche chemische Gruppen auf, welche stärker mit den selektiv ausgewählten Fremdstoffen wechselwirken und insbesondere zu einer größeren Änderung der Permittivität des Dielektrikums führen. So kann beispielsweise die Sensitivität gegenüber Wasser, Sauerstoff, flüchtigen Schwefelverbindungen oder Ammoniak erhöht werden.

In einer bevorzugten Ausführungsform des Systems kann das System mindestens zwei mit einer unterschiedlichen Menge an Vergussmasse bedeckte kapazitative Anordnungen aufweisen, wobei die Menge an Vergussmasse sich entlang einer Strecke von der kapazitativen Anordnung bis zu einer nächsten Oberfläche der Vergussmasse zwischen den beiden kapazitativen Anordnungen um größer oder gleich 20% und kleiner oder gleich 90% unterscheidet. Zur umfassenden Bestimmung des Betriebszustandes hat es sich als besonders geeignet herausgestellt, dass mindestens zwei kapazitive Anordnungen verwendet werden, wobei die beiden Anordnungen mit unterschiedlichen Mengen an Vergussmasse bedeckt sind. Die unterschiedlichen Mengen an Vergussmasse korrelieren mit der Tiefe der Anordnung im Modul oder aber ganz generell mit dem Abstand der Anordnung zur Oberfläche der Vergussmasse. Es können insofern die Eigenschaften der Vergussmasse gemessen werden, welche sich relativ nahe an der Oberfläche der Vergussmasse befindet. Die zweite Anordnung gibt über die Eigenschaften der Vergussmasse Auskunft, welche sich relativ im Inneren des Moduls befindet. Erstere Anordnung kann als Frühindikator angesehen werden, da diese Eigenschaften sich im Vergleich zu den Eigenschaften der Anordnung im Inneren des Moduls deutlich früher ändern sollten. Es werden zwei voneinander unabhängige Parameter erhalten, welche einzeln oder als kombinierter Parameter ausgewertet werden können. Somit lassen sich die Betriebseigenschaften des Moduls sicherer und differenzierter betrachten.

Beispiele und Ausführungsformen der vorliegenden Erfindung werden noch in exemplarischer Weise mit Bezug auf die Figuren 1 bis 3 beschrieben:

　　　Figur 1 zeigt schematisch einen Aufbau eines erfindungsgemäßen Systems;
　　　Figur 2 zeigt schematisch zeigt schematisch einen Aufbau eines erfindungsgemäßen Systems mit eindiffundierten Fremdstoffen;
　　　Figur 3 zeigt schematisch einen weiteren Aufbau eines erfindungsgemäßen Systems mit eindiffundierten Fremdstoffen;
　　　Figur 4 zeigt schematisch ein Leistungsmodul mit elektrischen Komponenten bedeckt von einer Vergussmasse.

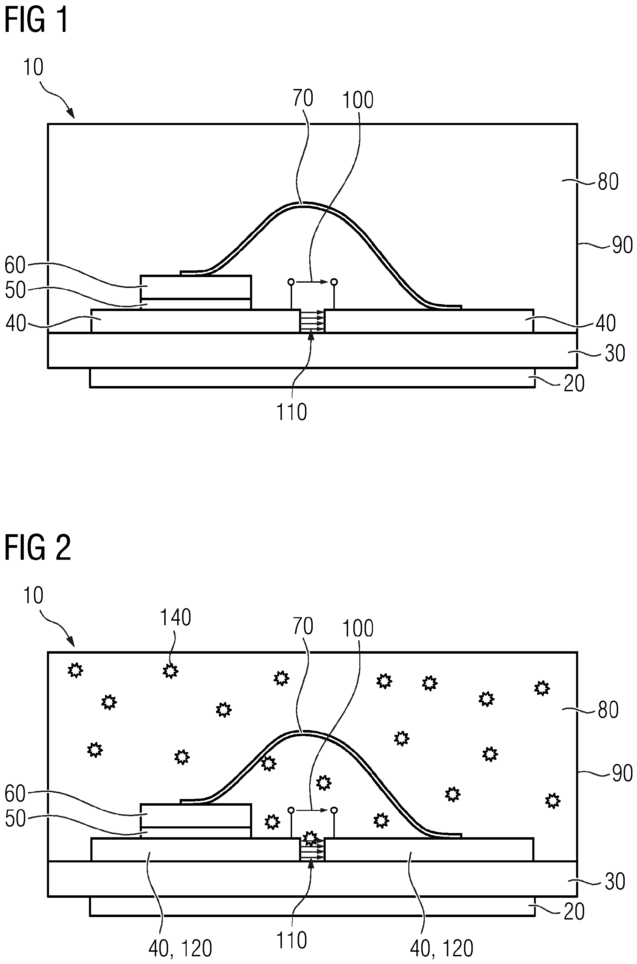

Die Figur 1 zeigt schematisch einen Aufbau eines erfindungsgemäßen Systems 10 umfassend ein Leistungshalbleiter-Modul. Das Leistungshalbleiter-Modul umfasst die üblichen Bestandteile eines Leistungshalbleiter-Moduls. Zu diesen Bestandteilen des Leistungshalbleiter-Moduls zählen untere Kupferanbindung 20 sowie Kupferleitungsbahnen 40, welche durch ein Substrat 30 getrennt sind. Auf einem der Kupferleitungsbahnen 40 ist ein Lot 50 aufgebracht, welches den eigentlichen Halbleiter-Chip 60 auf der Kupferleitungsbahn 40 fixiert. Der Halbleiter-Chip 60 ist über einen Bonddraht 70 mit einer weiteren Kupferleitungsbahn 40 elektrisch verbunden. Diese elektronischen Bestandteile des Leistungshalbleiter-Moduls werden von einer Vergussmasse 80 bedeckt oder sind in diese eingebettet. Das Leistungshalbleiter-Modul liegt in einem Gehäuse 90 gekapselt vor. In dieser Ausführungsform fungieren zwei der Kupferleitungsbahnen 40 als Teil der kapazitativen Anordnung 100. Diese Kupferleitungsbahnen 40 bilden zwei voneinander beabstandete, leitende, gegeneinander elektrisch isolierte Komponenten 120, wobei die Vergussmasse 80 sich zwischen diesen Komponenten 120 befindet. Es wird eine elektrische Kapazität ausgebildet, wobei die einzelnen Kupferleitungsbahnen 40 jeweils durch eine elektrische Anbindung kontaktiert werden. Zwischen den Kupferleitungsbahnen 40 wird ein elektrisches Feld 110 ausgebildet, dessen Stärke von den Eigenschaften der als Dielektrikums fungierenden Vergussmasse 80 abhängt. Unter einer festgelegten Geometrie der Kupferleitungsbahnen 40 ist beispielsweise die Kapazität der kapazitativen Anordnung 100 nur eine Funktion der Permittivität des Dielektrikums, also der Vergussmasse 80. Die kapazitativen Anordnung 100 weist eine elektrische Kontaktierung auf (nicht dargestellt), über die eine Messung der elektrischen Eigenschaften der kapazitativen Anordnung 100 ermöglicht wird. In dieser Ausgestaltung ist die kapazitative Anordnung 100 direkt im Inneren des Systems 10 angeordnet und ermöglicht die Detektion von Fremdstoffen (nicht dargestellt) direkt an den elektronischen Bauteilen des Moduls. In dieser Ausgestaltung können die Kupferleitungsbahnen 40 als leitende, gegeneinander elektrisch isolierte Komponenten 120 der kapazitativen Anordnung 100 angesehen werden. Zur Vereinfachung sind in dieser Figur die weiteren Bestandteile des erfindungsgemäßen Systems 10, die Messeinrichtung, welche zur Bestimmung der elektrischen Eigenschaften der kapazitativen Anordnung 100 eingerichtet ist, die Auswerteeinheit, welche einen Vergleich zwischen gemessenen Werten und Referenzwerten erlaubt und eine Anzeige- und/oder eine Speichereinheit, nicht dargestellt. Die Messeinrichtung kann über ein Kabel oder einen Draht mit der kapazitativen Anordnung 100 verbunden sein. Die Messeinrichtung ist zudem mit Anzeige- und/oder Speichereinheit des Systems verbunden (nicht gezeigt).

Die Figur 2 zeigt schematisch den Aufbau eines erfindungsgemäßen Leistungshalbleiter-Modul mit eindiffundierten Fremdstoffen 140. Die Figur 2 zeigt im Wesentlichen dieselben Aufbauten wie die Figur 1. Dargestellt sind die unteren 20 sowie Kupferleitungsbahnen 40, welche durch ein Substrat 30 getrennt sind. Eine der Kupferleitungsbahnen 40 trägt ein Lot 50, welches den Halbleiter-Chip 60 elektrisch kontaktiert und fixiert. Der Halbleiter-Chip 60 ist über einen Bonddraht 70 mit einer weiteren oberen Kupferleitungsbahn 40 elektrisch verbunden. Das Leistungshalbleiter-Modul ist von einer Vergussmasse 80 bedeckt und liegt in einem Gehäuse 90 gekapselt vor. In dieser Figur sind zusätzliche Fremdstoffe 140 dargestellt, welche aus der Umgebung in die Vergussmasse 80 eindiffundiert sind. Als Fremdstoffe 140 können beispielsweise Wasser oder weitere chemische Substanzen angesehen werden, welche sich üblicherweise nicht direkt nach der Herstellung in der Vergussmasse 80 befinden. Diese Fremdstoffe 140 können in den Fällen verstärkt in die Vergussmasse 80 eindringen, in denen die Vergussmasse 80 gealtert ist. Die Alterung der Vergussmasse 80 kann beispielsweise über eine verstärkte Temperaturbelastung oder durch das Eindringen der Fremdstoffe 140 selbst hervorgerufen werden. Die erhöhte Konzentration der Fremdstoffe 140 führt zu einer Änderung der Permittivität der Vergussmasse 80 zwischen den Kupferleitungsbahnen 40. Insofern ändern sich die elektrischen Eigenschaften des Dielektrikums. Aufgrund der festgelegten Geometrie der kapazitativen Anordnung 100, können Änderungen der elektrischen Eigenschaften nur durch Änderungen der elektrischen Eigenschaften der Vergussmasse 80 bedingt sein. Somit kann eine Aussage über den Betriebszustand des innerhalb des Systems 10 befindlichen Leistungshalbleiter-Moduls getroffen werden. Weichen aktuell gemessene Werte elektrischer Eigenschaften deutlich von gemessenen Referenzwerten ab, so ist das ein Zeichen für Veränderungen und einer Alterung des Leistungshalbleiter-Moduls im System 10. Der Vergleich kann auf einen oder mehreren Datenpunkten als Funktion der Zeit beruhen. Der Vergleich kann eine oder mehrere gemessene elektrische Parameter betreffen. Der Vergleich kann eine oder mehrere, an unterschiedlichen Stellen innerhalb des Systems 10 angeordnete, kapazitative Anordnungen 100 betreffen. In dieser Ausgestaltung können die Kupferleitungsbahnen 40 als leitende, gegeneinander elektrisch isolierte Komponenten 120 der kapazitativen Anordnung 100 angesehen werden. In dieser Figur ist die Auswerteeinheit und die Anzeige oder Speichereinheit nicht gezeigt.

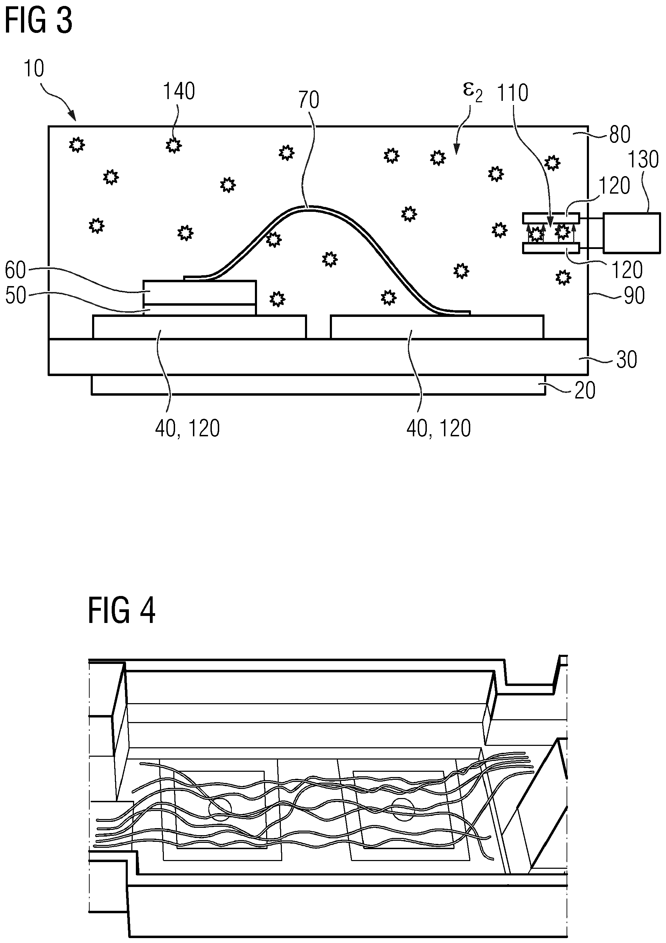

Die Figur 3 zeigt schematisch einen weiteren Aufbau eines erfindungsgemäßen Systems 10 mit einem Leistungshalbleiter-Modul mit eindiffundierten Fremdstoffen 140. In dieser Ausgestaltung sind dieselben Merkmale gezeigt wie in der Figur 2. In Abwandlung zu der Figur 2 werden für die kapazitative Anordnung 100 zwei zusätzliche leitende, gegeneinander elektrisch isolierte Komponenten 120 in die Vergussmasse 80 eingebracht. Diese leitenden, gegeneinander elektrisch isolierten Komponenten 120 können in Form flächiger Platten ausgestaltet sein, welche durch die Vergussmasse 80 getrennt vorliegen. Die Anordnung aus Vergussmasse 80 und leitenden, gegeneinander elektrisch isolierten Komponenten 120 kann als Plattenkondensator aufgefasst werden. Die leitenden, gegeneinander elektrisch isolierten Komponenten 120 können über eine elektrische Anbindung mit einer Auswerte-Einheit 130 verbunden sein. Die Auswerte-Einheit 130 kann die eigentliche Messeinrichtung, einen elektrischen Speicher und optionale eine Anzeige umfassen. Die kontinuierlich oder intervallweise gemessenen elektrischen Werte der kapazitativen Anordnung 100 werden in der Auswerte-Einheit 130 mit Referenzwerten verglichen und das Ergebnis kann abgespeichert oder wahlweise ausgegeben werden.

Die Figur 4 zeigt schematisch ein Leistungsmodul mit elektrischen Komponenten bedeckt von einer Vergussmasse.

Bezugszeichenliste

10     System

20 untere Kupferanbindung
30 Substrat
40 Kupferleitungsbahnen
50 Lot
60 Halbleiter-Chip
70 Bonddraht
80 Vergussmasse
90 Gehäuse
100 Kapazitative Anordnung
110 elektrisches Feld
120 leitende, gegeneinander elektrisch isolierte Komponenten
130 Auswerte-Einheit
140 Fremdstoffe

**Patentansprüche**

1. Verfahren zur Überprüfung des Betriebszustandes eines Leistungshalbleiter-Moduls umfassend ein oder mehrere zumindest teilweise durch eine Vergussmasse (80) überzogene, elektronische Bauteile in einem Gehäuse (90), **dadurch gekennzeichnet, dass** das Verfahren mindestens die Schritte umfasst:

   a) Bestimmung der elektrischen Eigenschaften mindestens einer innerhalb des Halbleiter-Moduls liegenden kapazitativen Anordnung (100) aus zwei voneinander beabstandeten, leitenden, gegeneinander elektrisch isolierten Komponenten (120) und einem elektrischen Isolator in Form eines zwischen diesen Komponenten (120) liegenden Teils der Vergussmasse (80), wobei der Isolator sich zumindest teilweise zwischen den leitenden, gegeneinander elektrisch isolierten Komponenten (120) erstreckt und diese jeweils an einer Oberfläche kontaktiert;
   b) Vergleich der im Verfahrensschritt a) bestimmten, elektrischen Eigenschaften mit einem vorgegebenen Referenzwert;
   c) Ausgeben einer Mitteilung und/oder Ablegen des Vergleichsergebnisses in einem elektronischen Speicher.

2. Verfahren nach Anspruch 1, wobei die zwei voneinander beabstandeten, leitenden, gegeneinander elektrisch isolierten Komponenten (120) elektronische Bauteile des Leistungshalbleiter-Moduls sind.

3. Verfahren einem der vorhergehenden Ansprüche, wobei der Verfahrensschritt a) unabhängig voneinander an zwei voneinander beabstandeten, kapazitativen Anordnungen (100) innerhalb des Leistungshalbleiter-Modul durchgeführt wird und der Vergleich im Verfahrensschritt b) auf Basis der elektrischen Eigenschaften beider Anordnungen (100) erfolgt.

4. Verfahren nach einem der vorhergehenden Ansprüche, wobei die Bestimmung der elektrischen Eigenschaften im Verfahrensschritt b) die Bestimmung der elektrischen Kapazität der kapazitativen Anordnung (100) umfasst.

5. Verfahren nach einem der vorhergehenden Ansprüche, wobei die Bestimmung der elektrischen Eigenschaften im Verfahrensschritt b) die Bestimmung der Impedanz der kapazitativen Anordnung (100) umfasst.

6. Verfahren nach einem der vorhergehenden Ansprüche, wobei die Bestimmung der elektrischen Eigenschaften im Verfahrensschritt b) die Bestimmung des Verlustwinkels und/oder des Verlustfaktors der kapazitativen Anordnung (100) umfasst.

7. Verfahren nach einem der vorhergehenden Ansprüche, wobei im Verfahrensschritt c) der Vergleich der gemessenen, elektrischen Eigenschaften mit einem vorgegebenen Referenzwert einen Vergleich mit den elektrischen Eigenschaften eines neuen Leistungshalbleiter-Moduls umfasst.

8. Verfahren nach einem der vorhergehenden Ansprüche, wobei im Verfahrensschritt c) der Vergleich der gemessenen, elektrischen Eigenschaften mit einem vorgegebenen Referenzwert einen Vergleich mit den Werten einer Kalibrationskurve umfasst, wobei die Kalibrationskurve die elektrischen Eigenschaften der kapazitativen Anordnung (100) als Funktion der Eigenschaften der Vergussmasse (80) umfasst.

9. Verfahren nach einem der vorhergehenden Ansprüche, wobei im Verfahrensschritt a) die Bestimmung der elektrischen Eigenschaften eine Messung einer elektrischen Teilentladung der kapazitativen Anordnung (100) umfasst.

10. System zur Bestimmung des Betriebszustandes eines Leistungshalbleiter-Moduls, **dadurch gekennzeichnet, dass** das System (10) mindestens umfasst:

   i) ein Leistungshalbleiter-Modul, umfassend elektronische Bauteile und eine Vergussmasse (80) in einem Gehäuse (90), wobei die Vergussmasse (80) zumindest Teile der Oberfläche der elektronischen Bauteile bedeckt;
   ii) eine kapazitative Anordnung (100), wobei die kapazitative Anordnung (100) aus zwei voneinander beabstandeten, leitenden, gegeneinander elektrisch isolierten Komponenten (120) und einem elektrischen Isolator in Form eines zwischen diesen Komponenten liegenden Teils der Vergussmasse (80) besteht, wobei der Isolator sich zumindest teilweise zwischen den leitenden, gegeneinander elektrisch isolierten Komponenten (120) erstreckt und diese jeweils an einer Oberfläche kontaktiert;

iii) eine Messeinrichtung eingerichtet zur Bestimmung der elektrischen Eigenschaften der kapazitativen Anordnung (100);

iv) eine Auswerteeinheit (130) dazu eingerichtet einen Vergleich zwischen gemessenen Werten und Referenzwerten durchzuführen;

v) eine Anzeige und/oder eine Speichereinheit.

11. System nach Anspruch 10, wobei die voneinander beabstandeten, leitenden, gegeneinander elektrisch isolierten Komponenten (120) der kapazitativen Anordnung (100) zwei Kupferleiterbahnen (40) auf einem Substrat (30) des Leistungshalbleiter-Moduls sind.

12. System nach Anspruch 10, wobei die voneinander beabstandeten, leitenden, gegeneinander elektrisch isolierten Komponenten (120) der kapazitativen Anordnung (100) zwei Metallplatten sind, wobei die Metallplatten die elektronischen Bauteile des Leistungshalbleiter-Moduls nicht kontaktieren.

13. System nach Anspruch 10, wobei die voneinander beabstandeten, leitenden, gegeneinander elektrisch isolierten Komponenten (120) der kapazitativen Anordnung (100) durch eine Kupferleiterbahn (40) auf einem Substrat (30) des Leistungshalbleiter-Moduls und aus einem Metallkontakt in Plattenform ausgebildet sind, wobei der Metallkontakt in Plattenform die elektronischen Bauteile des Leistungshalbleiter-Moduls nicht kontaktiert.

14. System nach einem der Ansprüche 10 bis 13, wobei zumindest im Bereich der kapazitativen Anordnung (100) die Vergussmasse (80) ein derivatisiertes Silikongel ist, wobei das derivatisierte Silikongel dazu eingerichtet ist, selektiv spezifische Substanzen zu absorbieren und seine elektrischen Eigenschaften als Funktion der absorbierten Stoffmenge der spezifischen Substanz zu ändern.

15. System nach einem der Ansprüche 10 bis 14, wobei das System (10) mindestens zwei mit einer unterschiedlichen Menge an Vergussmasse (80) bedeckte kapazitative Anordnungen (100) aufweist, wobei die Menge an Vergussmasse (80) sich entlang einer Strecke von der kapazitativen Anordnung (100) bis zu einer nächsten Oberfläche der Vergussmasse zwischen den beiden kapazitativen Anordnungen um größer oder gleich 20% und kleiner oder gleich 90% unterscheidet.

FIG 1

FIG 2

## FIG 3

## FIG 4

**Europäisches Patentamt**
**European Patent Office**
**Office européen des brevets**

# EUROPÄISCHER RECHERCHENBERICHT

Nummer der Anmeldung

EP 24 16 0605

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 11 2018 002579 T5 (MITSUBISHI ELECTRIC CORP [JP]) 19. März 2020 (2020-03-19) | 1-3,7, 10-15 | INV. G01R27/26 |
| A | * das ganze Dokument * ----- | 4-6,8,9 | G01R31/64 G01R31/26 |
| X | DE 10 2016 225654 A1 (BOSCH GMBH ROBERT [DE]) 21. Juni 2018 (2018-06-21) * das ganze Dokument * ----- | 1-15 | |
| X | DE 10 2021 109151 A1 (INFINEON TECHNOLOGIES AG [DE]) 21. Oktober 2021 (2021-10-21) * das ganze Dokument * ----- | 1-15 | |
| A | DE 10 2020 200573 A1 (MITSUBISHI ELECTRIC CORP [JP]) 6. August 2020 (2020-08-06) * das ganze Dokument * ----- | 1-15 | |
| A | DE 10 2022 117661 A1 (DEUTSCH ZENTR LUFT & RAUMFAHRT [DE]) 25. Januar 2024 (2024-01-25) * das ganze Dokument * ----- | 1-15 | |

**RECHERCHIERTE SACHGEBIETE (IPC)**

G01R
G01N

Der vorliegende Recherchenbericht wurde für alle Patentansprüche erstellt

| Recherchenort | Abschlußdatum der Recherche | Prüfer |
|---|---|---|
| München | 1. August 2024 | Ardelt, Per-Lennart |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 24 16 0605

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-08-2024

| Im Recherchenbericht angeführtes Patentdokument | Datum der Veröffentlichung | Mitglied(er) der Patentfamilie | Datum der Veröffentlichung |
|---|---|---|---|
| DE 112018002579 T5 | 19-03-2020 | CN 110612600 A | 24-12-2019 |
| | | DE 112018002579 T5 | 19-03-2020 |
| | | JP 6727428 B2 | 22-07-2020 |
| | | JP WO2018211735 A1 | 23-01-2020 |
| | | US 2020116780 A1 | 16-04-2020 |
| | | WO 2018211735 A1 | 22-11-2018 |
| DE 102016225654 A1 | 21-06-2018 | DE 102016225654 A1 | 21-06-2018 |
| | | EP 3559986 A1 | 30-10-2019 |
| | | TW 201834196 A | 16-09-2018 |
| | | US 2019378786 A1 | 12-12-2019 |
| | | WO 2018114411 A1 | 28-06-2018 |
| DE 102021109151 A1 | 21-10-2021 | CN 113552461 A | 26-10-2021 |
| | | DE 102021109151 A1 | 21-10-2021 |
| | | US 2021325454 A1 | 21-10-2021 |
| DE 102020200573 A1 | 06-08-2020 | CN 111537856 A | 14-08-2020 |
| | | DE 102020200573 A1 | 06-08-2020 |
| | | JP 7118019 B2 | 15-08-2022 |
| | | JP 2020125978 A | 20-08-2020 |
| | | US 2020247642 A1 | 06-08-2020 |
| DE 102022117661 A1 | 25-01-2024 | KEINE | |

EPO FORM P0461

Für nähere Einzelheiten zu diesem Anhang : siehe Amtsblatt des Europäischen Patentamts, Nr.12/82